(19) Europäisches Patentamt
European Patent Office
Office européen des brevets

(11) **EP 2 251 707 A1**

(12) **EUROPEAN PATENT APPLICATION**

(43) Date of publication:
**17.11.2010 Bulletin 2010/46**

(51) Int Cl.:
*G01S 7/491* (2006.01)    *G01S 17/02* (2006.01)
*G01S 17/32* (2006.01)    *H03K 17/94* (2006.01)

(21) Application number: **09006285.2**

(22) Date of filing: **08.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Yamatake Corporation**
**Tokyo 100-6419 (JP)**

(72) Inventor: **Ueno, Tatsuya**
**Tokyo 100-6419 (JP)**

(74) Representative: **Samson & Partner**
**Widenmayerstrasse 5**
**80538 München (DE)**

(54) **Reflective photoelectric switch and object detection method**

(57)  In a reflective photoelectric switch, a semiconductor laser (1) emits laser light. A laser driver (4) drives the semiconductor laser (1). A photodiode (2) detects an electrical signal including an interference waveform generated by a self-mixing effect. A period measuring unit (70) measures the period of an interference waveform included in the detected electrical signal. A counting unit (71) discriminates the frequencies of the periods of interference waveforms into frequencies N1, N2, N3, and N4. A determination unit (8) determines that the object exists at a distance longer than the reference distance, when the frequency N1 is largest, determines that the object exists at a distance shorter than the reference distance, when the frequency N4 is largest, compares in magnitude the frequency N2 with the frequency N3 when the frequency sum (N2 + N3) is largest, determines that the object exists at a distance longer than the reference distance, when the frequency N2 is larger, and determines that the object exists at a distance shorter than the reference distance, when the frequency N3 is larger.

F I G . 1

EP 2 251 707 A1

**Description**

Background of the Invention

The present invention relates to a reflective photoelectric switch and, more particularly, to a reflective photoelectric switch which detects whether the distance to an object is longer or shorter than a predetermined reference distance and an object detection method.

As a conventional reflective photoelectric switch, a distance setting reflective (BackGround Suppression to be abbreviated as BGS hereinafter) photoelectric switch is known, which detects whether the distance from the photoelectric switch to an object is longer or shorter than a predetermined reference distance (see Japanese Patent Laid-Open Nos. 63-102135 and 63-187237). Such a BGS photoelectric switch can detect only an object without detecting any background.

As a rangefinder using interference of laser light, a laser measuring instrument using interference (a self-mixing effect) between output light from a laser and return light from a measurement target is proposed as follows:

·Tadashi Ueda, Jun Yamada, and Susumu Shitoh, "Distance Meter Using Self-Mixing Effect of Semiconductor Laser", Papers for 1994 Tokai-Section Joint Conference of the 8 Institutes of Electrical and Related Engineers, 1994
·Jun Yamada, Susumu Shitoh, Norio Tuda, and Tadashi Ueda, "Study of Compact Distance Meter by Self-Mixing Effect of Laser Diode", Bulletin of Aichi Institute of Technology, Vol. 31B, pp. 35 - 42, 1996
·Guido Giuliani, Michele Norgia, Silvano Donati and Thierry Bosch, "Laser diode self-mixing technique for sensing applications", JOURNAL OF OPTICS A: PURE AND APPLIED OPTICS, pp. 283 - 294, 2002

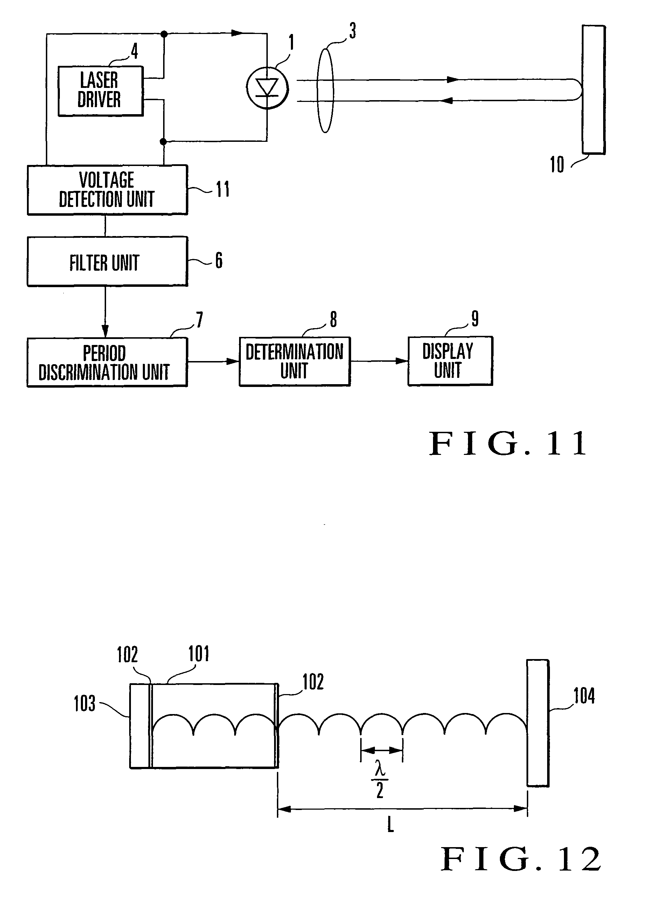

Fig. 12 shows a complex cavity model of an FP type (Fabry-Perot type) semiconductor laser. Referring to Fig. 12, reference numeral 101 denotes a semiconductor laser; 102, a cleavage plane of a semiconductor crystal; 103, a photodiode; and 104, a measurement target.

Let $\lambda$ be the oscillation wavelength of the laser and L be the distance from the cleavage plane 102 near the measurement target 104 to the measurement target 104. In this case, when the following resonance condition is satisfied, return light from the measurement target 104 and laser light in the cavity 101 strengthen each other. Consequently, the laser power slightly increases.

$$L = q\lambda/2 \qquad \qquad ...(1)$$

where q is an integer. This phenomenon can be sufficiently observed even with very weak scattered light from the measurement target 104 when an amplifying action occurs as the apparent reflectance inside the semiconductor laser cavity 101 increases.

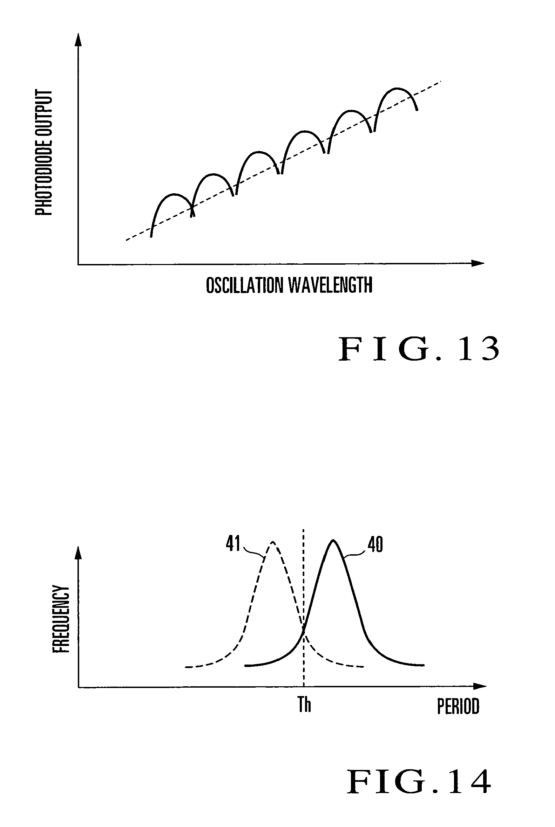

A semiconductor laser emits laser light having different frequencies in accordance with the magnitude of injection current. When modulating an oscillation frequency, this laser therefore allows direct modulation of the oscillation frequency by using an injection current without requiring any external modulator. Fig. 13 shows the relationship between the oscillation wavelength and the output waveform of the photodiode 103 when the oscillation wavelength of the semiconductor laser is changed at a predetermined rate. When $L = q\lambda/2$ indicated by equation (1) is satisfied, the phase difference between return light and laser light inside the cavity 101 becomes 0° (in phase), and the return light and the laser light inside the cavity 101 strengthen each other most. When $L = q\lambda/2 + \lambda/4$, the phase difference becomes 180° (in opposite phase), and the return light and the laser light inside the cavity 101 weaken each other most. As the oscillation wavelength of the semiconductor laser is changed, therefore, the laser power increases and decreases alternately and repeatedly. When the laser power is detected at this time by the photodiode 103 provided in the cavity 101, a stepwise waveform having a predetermined period like that shown in Fig. 13 is obtained. Such a waveform is generally called an interference fringe.

Each of the elements of this stepwise waveform, i.e., the interference fringe, is called a mode hop pulse (to be referred to as an MHP hereinafter). MHP is a phenomenon different from a mode hopping phenomenon. Assume that the distance to the measurement target 104 is represented by L1, and the number of MHPs is 10. In this case, as the distance decreases to L2 which is 1/2 of L1, the number of MHPs becomes five. That is, as the oscillation wavelength of the semiconductor laser changes in a predetermined time, the number of MHPs changes in proportion to the measurement distance. Therefore, detecting MHPs by the photodiode 103 and measuring the frequency of MHPs can easily measure the distance.

A BGS photoelectric switch can be implemented by using the above self-mixing type laser measuring instrument. It suffices to determine ON/OFF of the BGS photoelectric switch based on whether an object is at a short distance or a long distance compared with a predetermined reference distance. If a self-mixing type laser measuring instrument is to be used as a BGS photoelectric switch, it suffices to determine whether the average period of measured MHPs is longer or shorter than a known reference period of an MHP when an object is located at a reference distance. If the average period of the measured MHPs is longer than the known reference period of the MHP when the object is at the reference distance, it is determined that the object is located at a distance shorter than the reference distance, and ON is determined. If the average period of the measured MHPs is shorter than the known period, it is determined that the object is located at a distance longer than the reference distance, and OFF is determined.

As described above, using a self-mixing type laser measuring instrument can implement a BGS photoelectric switch. However, only comparing the simply obtained average period of MHPs with a reference period will degrade the determination accuracy. It is possible to improve the determination accuracy by using the technique proposed by the present inventor in Japanese Patent Application No. 2007-015020, i.e., obtaining the frequency distribution of the periods of MHPs, obtaining the representative value of the distribution, e.g., the median or mode, and calculating the distance to the object based on the representative value of the period distribution and the frequency distribution of the periods, and comparing the calculated distance with a reference distance. Such a method, however, requires a memory and a computer. This undesirably increases the cost of the BGS photoelectric switch.

When the object exists at a distance shorter than the reference distance, the distribution of the periods of MHPs shifts to the side where periods are longer than a reference period Th, as indicated by a distribution 40 in Fig. 14. In contrast to this, if the object 10 is at a distance longer than the reference distance, the distribution of the periods of MHPs shifts to the side where periods are shorter than the reference period Th, as indicated by a distribution 41 in Fig. 14. Therefore, comparing a number Nlong of MHPs having periods longer than the reference period Th with a number Nshort having periods shorter than the reference period Th can determine, with a simple, inexpensive arrangement, whether the object is at a distance longer or shorter than the reference distance. In this determination method, if Nlong > Nshort holds, it is determined that the object exists at a distance shorter than the reference distance. If Nlong < Nshort holds, it is determined that the object exists at a distance longer than the reference distance.

In the method of performing determination by comparing the number Nlong of MHPs having periods longer than the reference period Th with the number Nshort of MHPs having periods shorter than the reference period Th, noise such as disturbance light may be counted as an MHP or some MHP cannot be counted due to partial omission of a signal. This may cause an error in the measured period of an MHP. There is therefore a possibility that a determination error will occur when the object is located near the reference distance.

Summary of the Invention

It is an object of the present invention to provide a high-accuracy reflective photoelectric switch with a simple, inexpensive arrangement by using a self-mixing type laser measuring instrument.

It is another object of the present invention to provide a reflective photoelectric switch which can correct an error in a measured period and perform accurate determination concerning the distance to an object and an object detection method.

According to the present invention, there is provided a reflective photoelectric switch comprising a semiconductor laser which emits laser light, a laser driver which drives the semiconductor laser, detection means for detecting an electrical signal including an interference waveform generated by a self-mixing effect between laser light emitted from the semiconductor laser and return light from an object existing ahead of the semiconductor laser, period measuring means for measuring a period of an interference waveform included in an output signal from the detection means every time an interference waveform is input, counting means for discriminating frequencies of periods of interference waveforms measured by the period measuring means into four frequencies including a frequency N1 of periods less than a first predetermined number multiple of a reference period which is a period of an interference waveform when the object is located at a reference distance, a frequency N2 of periods not less than the first predetermined number multiple of the reference period and less than the reference period, a frequency N3 of periods not less than the reference period and less than a second predetermined number multiple of the reference period (first predetermined number < second predetermined number), and a frequency N4 of periods not less than the second predetermined number multiple of the reference period, and determination means for comparing in magnitude the frequency N1, the frequency N4, and a frequency sum (N2 + N3), determining that the object exists at a distance longer than the reference distance, when the frequency N1 is largest, determining that the object exists at a distance shorter than the reference distance, when the frequency N4 is largest, comparing in magnitude the frequency N2 with the frequency N3 when the frequency sum (N2 + N3) is largest, determining that the object exists at a distance longer than the reference distance, when the frequency N2 is larger, and determining that the object exists at a distance shorter than the reference distance, when the frequency N3 is larger.

In addition, according to the present invention, there is provided an object detection method comprising the steps of driving a semiconductor laser by supplying a driving current thereto, detecting an electrical signal including an interference waveform generated by a self-mixing effect between laser light emitted from the semiconductor laser and return light from an object existing ahead of the semiconductor laser, measuring a period of an interference waveform included in a detected electrical signal every time an interference waveform is input, discriminating frequencies of measured periods of interference waveforms into a frequency N1 of periods less than a first predetermined number multiple of a reference period which is a period of an interference waveform when the object is located at a reference distance, a frequency N2 of periods not less than the first predetermined number multiple of the reference period and less than the reference period, a frequency N3 of periods not less than the reference period and less than a second predetermined number multiple of the reference period (first predetermined number < second predetermined number), and a frequency N4 of periods not less than the second predetermined number multiple of the reference period, and comparing in magnitude the frequency N1, the frequency N4, and a frequency sum (N2 + N3), determining that the object exists at a distance longer than the reference distance, when the frequency N1 is largest, determining that the object exists at a distance shorter than the reference distance, when the frequency N4 is largest, comparing in magnitude the frequency N2 with the frequency N3 when the frequency sum (N2 + N3) is largest, determining that the object exists at a distance longer than the reference distance, when the frequency N2 is larger, and determining that the object exists at a distance shorter than the reference distance, when the frequency N3 is larger.

Brief Description of the Drawings

Fig. 1 is a block diagram showing the arrangement of a BGS photoelectric switch according to the first embodiment of the present invention;
Fig. 2 is a chart showing an example of a temporal change in the oscillation wavelength of a semiconductor laser according to the first embodiment of the present invention;
Figs. 3A and 3B are waveform charts schematically showing an output voltage waveform from a current/voltage conversion amplifying unit and an output voltage waveform from a filter unit in the first embodiment of the present invention;
Fig. 4 is a block diagram showing the arrangement of the period discrimination unit of the BGS photoelectric switch according to the first embodiment of the present invention;
Fig. 5 is a waveform chart schematically showing an output voltage waveform from the filter unit of the BGS photoelectric switch according to the first embodiment of the present invention;
Fig. 6 is a graph showing the frequency distribution of the periods of mode hop pulses when waveform dropout has occurred in the first embodiment of the present invention;
Fig. 7 is a graph showing the frequency distribution of the periods of mode hop pulses when each period is divided into two parts by noise in the first embodiment of the present invention;
Fig. 8 is a block diagram showing the arrangement of the period discrimination unit of a BGS photoelectric switch according to the second embodiment of the present invention;
Fig. 9 is a graph showing the frequency distributions of the periods of mode hop pulses when the periods of mode hop pulses are divided by noise, waveform dropout has occurred, and an object is not at standstill;
Fig. 10 is a block diagram showing the arrangement of the period discrimination unit of a BGS photoelectric switch according to the fourth embodiment of the present invention;
Fig. 11 is a block diagram showing the arrangement of a BGS photoelectric switch according to the fifth embodiment of the present invention;
Fig. 12 is a view showing a complex cavity model of a semiconductor laser in a conventional laser measuring instrument;
Fig. 13 is a graph showing the relationship between the oscillation wavelength of the semiconductor laser and an output waveform from a built-in photodiode; and
Fig. 14 is a graph showing the relationship between the distance to an object and the frequency distribution of the periods of mode hop pulses.

Description of the Preferred Embodiments

[First Embodiment]

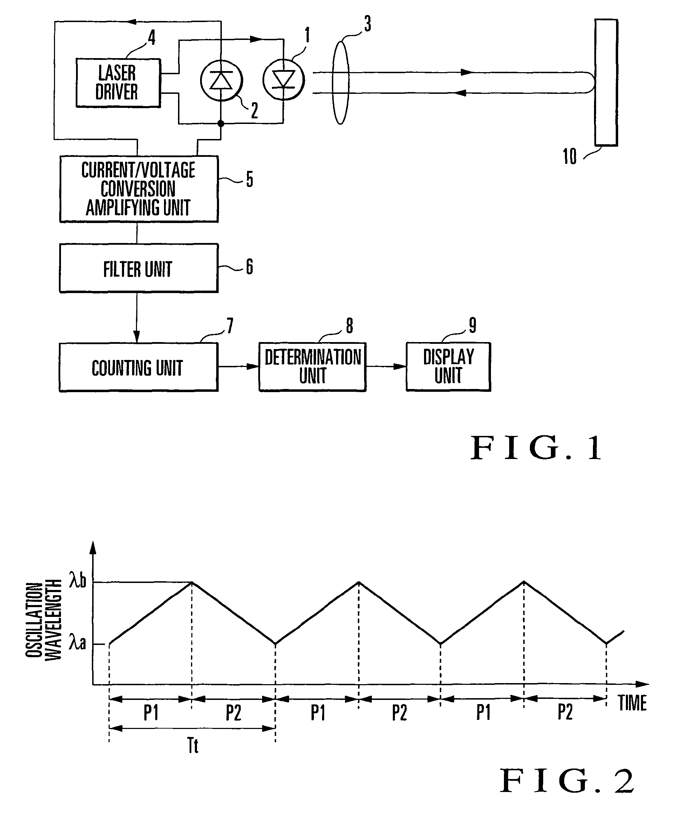

The first embodiment of the present invention will be described below with reference to the accompanying drawings. Fig. 1 shows the arrangement of a BGS photoelectric switch according to the first embodiment of the present invention. The BGS photoelectric switch in Fig. 1 includes a semiconductor laser 1 which emits laser light, a photodiode 2 which converts an optical output from the semiconductor laser 1 into an electrical signal, a lens 3 which focuses light from the semiconductor laser 1 to radiate it and also focuses return light from an object 10 to make it strike the semiconductor laser 1, a laser driver 4 which drives the semiconductor laser 1, a current/voltage conversion amplifying unit 5 which converts an output current from the photodiode 2 into a voltage and amplifies it, a filter unit 6 which removes a carrier wave from an output voltage from the current/voltage conversion amplifying unit 5, a period discrimination unit 7 which measures the periods of MHPs contained in an output voltage from the filter unit 6 and discriminates the frequencies of the periods of the MHPs with values based on a reference period, a determination unit 8 which determines from the discrimination result obtained by the period discrimination unit 7 whether the object 10 is at a distance shorter or longer than a predetermined reference distance, and a display unit 9 which displays the determination result obtained by the determination unit 8.

The photodiode 2 and the current/voltage conversion amplifying unit 5 constitute a detection means. For easy description, assume that as the semiconductor laser 1, a type (VCSEL type or DFB laser type) of laser which has no mode hopping phenomenon is used.

The laser driver 4 supplies, to the semiconductor laser 1, a triangular wave driving current which repeatedly increases and decreases at a constant change rate with respect to time as an injection current. With this operation, the semiconductor laser 1 is driven to alternately repeat the first oscillation interval in which the oscillation wavelength continuously increases at a constant change rate in proportion to the magnitude of an injection current and the second oscillation interval in which the oscillation wavelength continuously decreases at a constant change rate. Fig. 2 shows a temporal change in the oscillation wavelength of the semiconductor laser 1. Referring to Fig. 2, reference symbol P1 denotes the first oscillation interval; P2, the second oscillation interval; $\lambda a$, the minimum value of the oscillation wavelength in each interval; $\lambda b$, the maximum value of the oscillation wavelength in each interval; and Tt, the period of a rectangular wave. In this embodiment, the maximum value $\lambda b$ and minimum value $\lambda a$ of the oscillation wavelength are kept constant, and a difference $\lambda b - \lambda a$ between them is also kept constant.

The laser light emitted from the semiconductor laser 1 is focused by the lens 3 and strikes the object 10. The light reflected by the object 10 is focused by the lens 3 and strikes the semiconductor laser 1. It is not, however, essential that the lens 3 focuses light. The photodiode 2 is placed inside or near the semiconductor laser 1 and converts an optical output from the semiconductor laser 1 into a current. The current/voltage conversion amplifying 5 converts an output current from the photodiode 2 into a voltage and amplifies it.

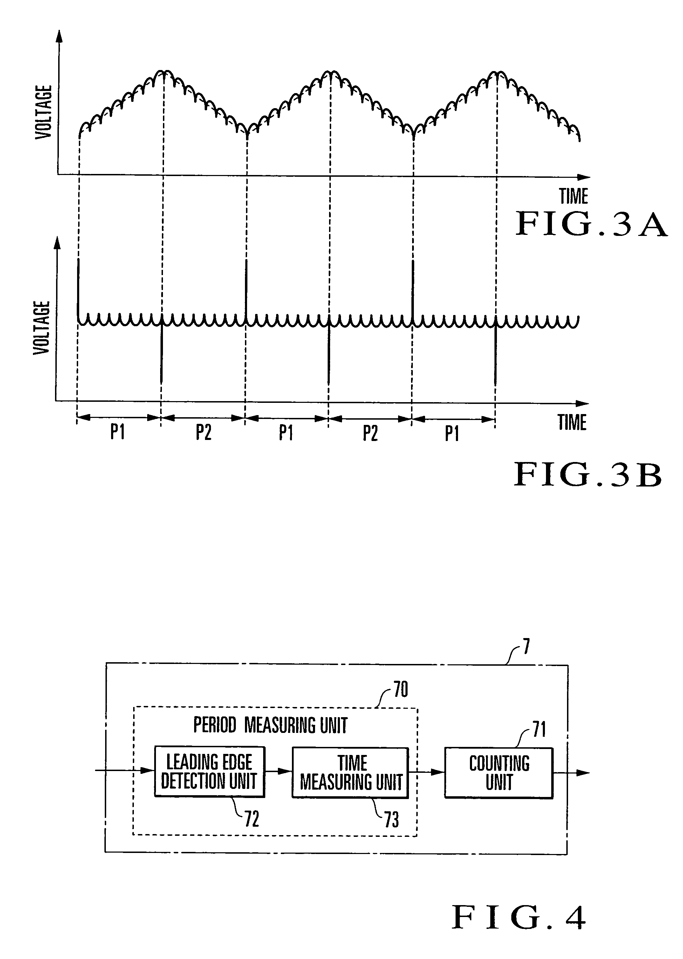

The filter unit 6 has a function of extracting a superimposed signal from a modulated wave. Fig. 3A schematically shows an output voltage waveform from the current/voltage conversion amplifying unit 5. Fig. 3B schematically shows an output voltage waveform from the filter unit 6. Figs. 3A and 3B show the process of extracting the MHP waveform (interference waveform) in Fig. 3B by removing the oscillation waveform (carrier wave) of the semiconductor laser 1 in Fig. 2 from the waveform (modulated wave) in Fig. 3A which corresponds to an output from the photodiode 2.

The period discrimination unit 7 measures the periods of MHPs contained in an output voltage from the filter unit 6, and discriminates the frequencies of the periods of the MHPs with values based on the known period of an MHP (to be referred to as a reference period Th hereinafter) when the object 10 is at a predetermined reference distance. Fig. 4 shows the arrangement of the period discrimination unit 7. The period discrimination unit 7 includes a period measuring unit 70 and a counting unit 71. The period measuring unit 70 includes a leading edge detection unit 72 and a time measuring unit 73.

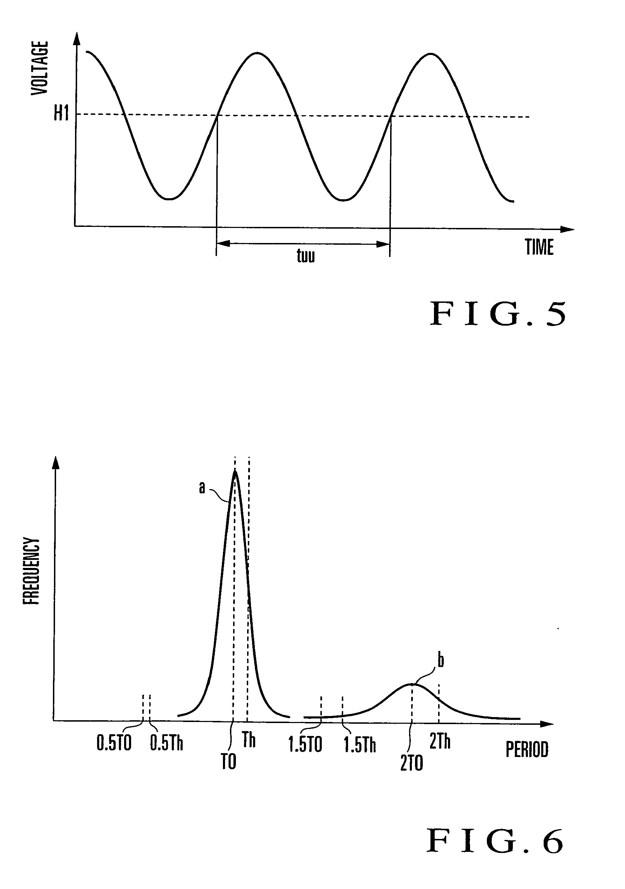

Fig. 5 explains the operation of the period measuring unit 70 and schematically shows an output voltage waveform from the filter unit 6, i.e., the waveform of an MHP. Referring to Fig. 5, reference symbol H1 denotes a threshold for detecting the leading edge of an MHP.

The leading edge detection unit 72 detects the leading edge of an MHP by comparing an output voltage from the filter unit 6 with the threshold H1. The time measuring unit 73 measures a time tuu from the leading edge of an MHP to the next leading edge (i.e., the period of the MHP) based on the detection result obtained by the leading edge detection unit 72. The time measuring unit 73 performs such measurement every time the leading edge of an MHP is detected.

The counting unit 71 discriminates the frequencies of periods T of MHPs measured by the period measuring unit 70 into four frequencies, namely a frequency N1 of periods less than 0.5 times the reference period Th ($0.5Th > T$), a frequency N2 of periods equal to or more than 0.5 times the reference period Th and less than the reference period Th ($0.5Th \leq T < Th$), a frequency N3 of periods equal to or more than the reference period Th and less than 1.5 times the reference period Th ($Th \leq T < 1.5Th$), and a frequency N4 of periods equal to or more than 1.5 times the reference period Th ($1.5Th \leq T$).

In the above manner, the period discrimination unit 7 discriminates the frequencies of the periods of MHPs. The period discrimination unit 7 measures the periods of MHPs in each measurement interval (each of the first oscillation interval P1 and the second oscillation interval P2 in this embodiment), and discriminates the frequencies of the periods.

The determination unit 8 then determines from the measurement result obtained by the period discrimination unit 7 whether the object 10 is at a distance shorter or longer than the reference distance. The determination unit 8 compares in magnitude the frequencies N1 and N4 of the periods of the MHPs and a frequency sum (N2 + N3). If the frequency N1 is largest, the determination unit 8 determines that the object 10 exists at a distance longer than the reference distance. If the frequency N4 is largest, the determination unit 8 determines that the object 10 exists at a distance shorter than the reference distance. If the frequency sum (N2 + N3) is largest, the determination unit 8 compares in magnitude the frequencies N2 and N3. If the frequency N2 is larger than the frequency N3, the determination unit 8 determines that the object 10 exists at a distance longer than the reference distance. If the frequency N3 is larger than the frequency N2, the determination unit 8 determines that the object 10 exists at a distance shorter than the reference distance.

The determination unit 8 performs such determination for each measurement interval (each of the first oscillation interval P1 and the second oscillation interval P2 in this embodiment) in which the period discrimination unit 7 measures and discriminates the periods of MHPs. The display unit 9 displays the determination result obtained by the determination unit 8.

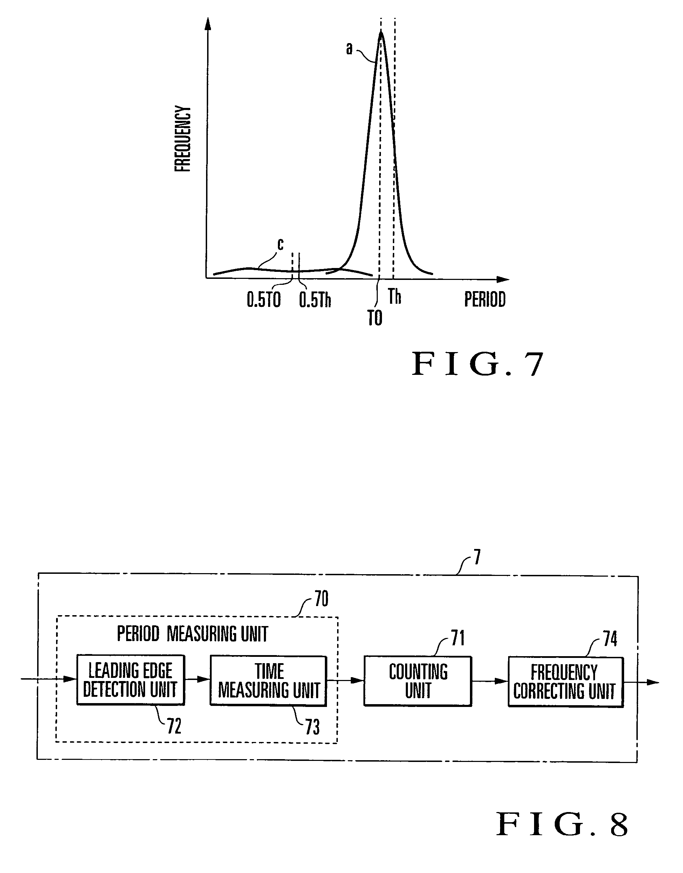

Figs. 6 and 7 explain the determination principle in this embodiment. Fig. 6 shows the frequency distribution of the periods of MHPs when waveform dropout has occurred. Fig. 7 shows the frequency distribution of the periods of MHPs when each period is divided into two parts by noise. Referring to Figs. 6 and 7, reference symbol T0 denotes the representative value (median or mode) of a frequency distribution a of the proper periods of MHPs.

If, for example, MHP dropout (detection omission) occurs at the time of measurement of periods because of the low intensity of the MHP, the period of the MHP at the position of the occurrence of the dropout becomes twice the proper period. The frequency distribution of the periods of MHPs which is caused by such dropout becomes a normal distribution centered on 2T0 ("b" in Fig. 6). The frequency distribution b is similar to the frequency distribution a of the proper periods of MHPs. If noise is erroneously detected as an MHP at the time of measurement of periods, the period of the MHP is divided into two parts at a random ratio.

The frequency distribution of the periods of MHPs each divided into two parts as a result of excessive counting of noise becomes symmetrical about 0.5T0 ("c" in Fig. 7).

In this embodiment, the frequencies of the periods of MHPs are classified into four categories as described above. If the frequency N1 of periods less than 0.5 times the reference period Th is largest, the frequency N1 is regarded as being based on the proper periods of MHPs instead of noise, and it is determined that the object 10 exists at a distance longer than the reference distance. If the frequency N4 of periods equal to or more than 1.5 times the reference period Th is largest, the frequency N4 is regarded as being based on the proper periods of MHPs instead of MHP dropout, and it is determined that the object 10 exists at a distance shorter than the reference distance. If it cannot be determined from the frequency N1 or N4 whether the object 10 is at a distance longer or shorter than the reference distance, the frequencies N1 and N4 are ignored, and whether the object 10 is at a distance longer or shorter than the reference distance is determined by comparing in magnitude the frequency N2 of periods equal to or more than 0.5 times the reference period Th and less than the reference period Th with the frequency N3 of periods equal to or more than the reference period Th and less than 1.5 the reference period Th.

In this manner, this embodiment can properly determine whether the distance from the BGS photoelectric switch to the object 10 (more accurately, the distance from the semiconductor laser 1 to the object 10) is longer or shorter than the reference distance, by removing the influences of MHP dropout or excessive noise detection at the time of measurement of periods. The period discrimination unit 7 and the determination unit 8 can be implemented by a computer including a CPU, storage device, and interface and programs stored in the storage device or hardware. In this embodiment, since it suffices to perform only the measurement of the periods of MHPs, the discrimination of the periods, and the comparison between the magnitudes of the frequencies, the period discrimination unit 7 and the determination unit 8 can be implemented by simple arrangements.

[Second Embodiment]

The second embodiment of the present invention will be described next. The overall arrangement of a BGS photoelectric switch according to this embodiment is the same as that according to the first embodiment, and hence will be described by using the same reference numerals as those in Fig. 1. Fig. 8 shows the arrangement of a period discrimination unit 7 of the BGS photoelectric switch according to the second embodiment of the present invention. The period discrimination unit 7 in this embodiment has the same arrangement as that in the first embodiment except that a frequency correcting unit 74 is added. The operations of a period measuring unit 70 and counting unit 71 are the same as those in the first embodiment.

The frequency correcting unit 74 calculates a correction value N2' for a frequency N2 of periods equal to or more than 0.5 times a reference period Th and less than the reference period Th and a correction value N3' for a frequency N3 of periods equal to or more than the reference period Th and less than 1.5 times the reference period Th in the following manner.

$$N2' = N2 - N1 \qquad \qquad \cdots (2)$$

$$N3' = N3 + N1 \qquad\qquad ...(3)$$

The frequency correcting unit 74 notifies a determination unit 8 of the frequencies N1, N2, N3, and N4 obtained by the counting unit 71 and the correction values N2' and N3' obtained by itself. As in the first embodiment, the period discrimination unit 7 discriminates the frequency of the periods of MHPs in each measurement interval and calculates a correction value for the frequency. Note that the frequency correcting unit 74 may calculate one of the correction values N2' and N3'.

The determination unit 8 in this embodiment then compares in magnitude the frequencies N1 and N4 of the periods of MHPs and a frequency sum (N2 + N3). If the frequency N1 is largest, the determination unit 8 determines that an object 10 exists at a distance longer than a reference distance. If the frequency N4 is largest, the determination unit 8 determines that the object 10 exists at a distance shorter than the reference distance. If the frequency sum (N2 + N3) is largest, the determination unit 8 compares in magnitude the correction value N2' for the frequency with the frequency N3. If the correction value N2' is larger than the frequency N3, the determination unit 8 determines that the object 10 exists at a distance longer than the reference distance. If the frequency N3 is larger than the correction value N2', the determination unit 8 determines that the object 10 exists at a distance shorter than the reference distance. The determination unit 8 performs such determination for each measurement interval.

When the frequency correcting unit 74 calculates the correction value N3', the determination unit 8 performs the following determination. That is, the determination unit 8 compares in magnitude the frequencies N1 and N4 of the periods of MHPs and the frequency sum (N2 + N3). If the frequency N1 is largest, the determination unit 8 determines that the object 10 exists at a distance longer than the reference distance. If the frequency N4 is largest, the determination unit 8 determines that the object 10 exists at a distance shorter than the reference distance. If the frequency sum (N2 + N3) is largest, the determination unit 8 compares in magnitude the frequency N2 with the correction value N3' for the frequency. If the frequency N2 is larger than the correction value N3' for the frequency, the determination unit 8 determines that the object 10 exists at a distance longer than the reference distance. If the correction value N3' for the frequency is larger than the frequency N2, the determination unit 8 determines that the object 10 exists at a distance shorter than the reference distance.

The other components of the BGS photoelectric switch are the same as those described in the first embodiment.

As shown in Fig. 7, a frequency distribution c of the periods of MHPs each divided into two parts as a result of excessive counting of noise at the time of measurement of periods often overlaps a frequency distribution a of the proper periods of MHPs. This embodiment is therefore configured to correct the frequency N2 of periods equal to or more than 0.5 times the reference period Th and less than the reference period Th according to equation (2), and to correct the frequency N3 of periods equal to or more than the reference period Th and less than 1.5 times the reference period Th according to equation (3).

In this manner, this embodiment can effectively remove the influences of excessive noise detection at the time of measurement of periods. This makes it possible to further improve the determination accuracy concerning the distance to the object 10 as compared with the first embodiment. [Third Embodiment]

The third embodiment of the present invention will be described next. The arrangement of a BGS photoelectric switch according to this embodiment is the same as that according to the first embodiment, and hence will be described by using the same reference numerals as those in Figs. 1 and 4. The operations of a period discrimination unit 7 and period measuring unit 70 are the same as those in the first embodiment.

As in the first embodiment, a counting unit 71 in the third embodiment discriminates the frequencies of periods T of MHPs measured by the period measuring unit 70 into four frequencies, namely a frequency N1 of periods less than 0.5 times a reference period Th ($0.5Th > T$), a frequency N2 of periods equal to or more than 0.5 times the reference period Th and less than the reference period Th ($0.5Th \leq T < Th$), a frequency N3 of periods equal to or more than the reference period Th and less than 1.5 times the reference period Th ($Th \leq T < 1.5Th$), and a frequency N4 of periods equal to or more than 1.5 times the reference period Th ($1.5Th \leq T$).

As in the first embodiment, a determination unit 8 compares in magnitude the frequencies N1 and N4 of the periods of the MHPs and a frequency sum (N2 + N3). If the frequency N1 is largest, the determination unit 8 determines that an object 10 exists at a distance longer than the reference distance. If the frequency N4 is largest, the determination unit 8 determines that the object 10 exists at a distance shorter than the reference distance. If the frequency sum (N2 + N3) is largest, with reference to a period nTh (n is an integer equal to or more than 2) of an integer multiple of the reference period Th, the determination unit 8 adds, to the frequency N2, the frequency of the periods T near the period nTh and less than the period nTh, and adds, to the frequency N3, the frequency of the periods T near the period nTh and equal to or more than the period nTh. For example, the determination unit 8 adds, to the frequency N2, the frequency of periods equal to or more than 1.5 times the reference period Th and less than 2 times the reference period Th, and adds, to the frequency N3, the frequency of periods equal to or more than 2 times the reference period Th and less than 2.5 times the reference period Th. The determination unit 8 then compares in magnitude the frequencies N2 and N3 after this addition. If the frequency N2 is larger than the frequency N3, the determination unit 8 determines that the object 10 exists at a distance longer than the reference distance. If the frequency N3 is larger than the frequency N2, the determination unit 8 determines that the object 10 exists at a distance shorter than the reference distance. The other components of the BGS photoelectric switch are the same as those described in the first embodiment.

This embodiment exemplifies a correction method for a case in which MHP dropout occurs at the time of measurement of the periods of MHPs, and is effective when N3 < N2 < (N3 + N4) holds in the measurement result obtained by the period measuring unit 70. Note that when this embodiment is to be used in combination with the second embodiment, it is necessary to use the correction value N2'. The above addition is performed for the correction value N2' and the frequency N3.

[Fourth Embodiment]

In the first to third embodiments, it may be erroneously determined that the object 10 is not at standstill. This is because when the object 10 existing ahead of the semiconductor laser is moving in a direction toward the BGS photoelectric switch in an oscillation interval, the number of MHPs increases (the periods of MHPs decrease) in the first oscillation interval P1, and the number of MHPs decreases (the periods of MHPs increase) in the second oscillation interval P2.

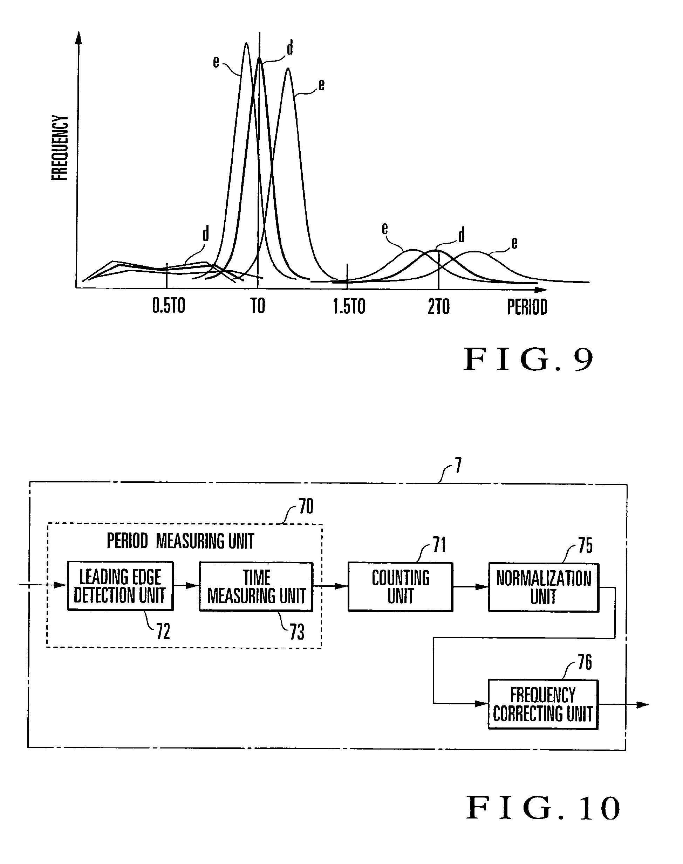

Fig. 9 shows the frequency distributions of the periods of MHPs when the periods of MHPs are divided by noise, waveform dropout has occurred, and an object is not at standstill. Assume that the manner of division of the periods of MHPs by noise and the frequency rate of waveform dropout in a first oscillation interval P1 are the same as those in a second oscillation interval P2. In this case, performing determination upon normalization of frequencies makes it possible to properly determine whether the distance from the BGS photoelectric switch to the object 10 (more accurately, the distance from a semiconductor laser 1 to the object 10) is longer or shorter than the reference distance, even if the object 10 moves.

The overall arrangement of the BGS photoelectric switch in this embodiment is also the same as that in the first embodiment, and hence will be described by using the same reference numerals as those in Fig. 1. Fig. 10 shows the arrangement of a period discrimination unit 7 of the BGS photoelectric switch according to the fourth embodiment of the present invention. The arrangement of the period discrimination unit 7 in this embodiment is the same as that in the first embodiment except that a normalization unit 75 and a frequency correcting unit 76 are added. The operations of a period measuring unit 70 and counting unit 71 are the same as those in the first embodiment.

In this embodiment, frequencies N1, N2, N3, and N4 obtained by the counting unit 71 in the first oscillation interval P1 are set as N1(P1), N2(P1), N3(P1), and N4(P1), respectively, and frequencies N1, N2, N3, and N4 obtained by the counting unit 71 in the second oscillation interval P2 are set as N1(P2), N2(P2), N3(P2), and N4(P2), respectively.

The normalization unit 75 normalizes the frequencies N1, N2, N3, and N4 for each oscillation interval with the frequencies in each oscillation interval, and adds each of the normalized frequencies N1, N2, N3, and N4 in the first oscillation interval P1 to a corresponding one of the normalized frequencies N1, N2, N3, and N4 in the second oscillation interval P2, thereby obtaining frequencies N1", N2", N3", and N4" according to the following equations:

$$N1" = \{N1(P1) / (N1(P1) + N2(P1) + N3(P1) + N4(P1))\} + \{N1(P2) / (N1(P2) + N2(P2) + N3(P2) + N4(P2))\} \quad ...(4)$$

$$N2" = \{N2(P1) / (N1(P1) + N2(P1) + N3(P1) + N4(P1))\} + \{N2(P2) / (N1(P2) + N2(P2) + N3(P2) + N4(P2))\} \quad ...(5)$$

$$N3'' = \{N3(P1)$$
$$/(N1(P1) + N2(P1) + N3(P1) + N4(P1))\}$$
$$+ \{N3(P2)$$
$$/(N1(P2) + N2(P2) + N3(P2) + N4(P2))\} \quad ...(6)$$

$$N4'' = \{N4(P1)$$
$$/(N1(P1) + N2(P1) + N3(P1) + N4(P1))\}$$
$$+ \{N4(P2)$$
$$/(N1(P2) + N2(P2) + N3(P2) + N4(P2))\} \quad ...(7)$$

The frequency correcting unit 76 calculates a correction value N2' for the frequency N2" and a correction value N3' for the frequency N3" as follows:

$$N2' = N2'' - N1'' \qquad\qquad ...(8)$$

$$N3' = N3'' + N1'' \qquad\qquad ...(9)$$

The frequency correcting unit 76 notifies a determination unit 8 of the frequencies N1", N2", N3", and N4" obtained by the normalization unit 75 and the correction values N2' and N3' obtained by itself. In this embodiment, in order to obtain the sums of frequencies in the first oscillation interval P1 and the second oscillation interval P2, the period discrimination unit 7 operates for each oscillation period (the period of each triangular wave). Note that the frequency correcting unit 76 may calculate one of the correction values N2' and N3'.

The determination unit 8 in this embodiment then compares in magnitude the frequencies N1" and N4" of the periods of MHPs and a frequency sum (N2" + N3"). If the frequency N1" is largest, the determination unit 8 determines that the object 10 exists at a distance longer than the reference distance. If the frequency N4" is largest, the determination unit 8 determines that the object 10 exists at a distance shorter than the reference distance. If the frequency sum (N2" + N3") is largest, the determination unit 8 compares in magnitude the correction value N2' for the frequency with the frequency N3". If the correction value N2 is larger than the frequency N3", the determination unit 8 determines that the object 10 exists at a distance longer than the reference distance. If the frequency N3" is larger than the correction value N2', the determination unit 8 determines that the object 10 exists at a distance shorter than the object 10. The determination unit 8 performs such determination for each oscillation period (the period of each triangular wave).

When the frequency correcting unit 76 calculates the correction value N3', the determination unit 8 performs the following determination. That is, the determination unit 8 compares in magnitude the frequencies N1" and N4" of the periods of MHPs and the frequency sum (N2" + N3"). If the frequency N1" is largest, the determination unit 8 determines that the object 10 exists at a distance longer than the reference distance. If the frequency N4" is largest, the determination unit 8 determines that the object 10 exists at a distance shorter than the reference distance. If the frequency sum (N2" + N3") is largest, the determination unit 8 compares in magnitude the frequency N2" with the correction value N3' for the frequency. If the frequency N2" is larger than the correction value N3' for the frequency, the determination unit 8 determines that the object 10 exists at a distance longer than the reference distance. If the correction value N3' for the frequency is larger than the frequency N2", the determination unit 8 determines that the object 10 exists at a distance shorter than the reference distance.

The other components of the BGS photoelectric switch are the same as those described in the first embodiment.

This embodiment can effectively remove the influences of excessive noise detection at the time of measurement of periods, and can properly perform determination concerning the distance to the object 10, even if the object 10 moves.

[Fifth Embodiment]

In the first to fourth embodiments, although an MHP waveform is extracted from an output signal from a photodiode serving as a photoreceiver, it is possible to extract an MHP waveform without using any photodiode. Fig. 11 shows the arrangement of a BGS photoelectric switch according to the fifth embodiment of the present invention. The same reference numerals as in Fig. 1 denote the same components in Fig. 11. The BGS photoelectric switch of this embodiment uses a voltage detection unit 11 instead of the photodiode 2 and the current/voltage conversion amplifying unit 5 in the first to fourth embodiments.

A voltage detection unit 11 detects and amplifies the inter-terminal voltage of a semiconductor laser 1, i.e., the voltage between the anode and the cathode. When the laser light emitted from the semiconductor laser 1 interferes with return light from an object 10, an MHP waveform appears in the inter-terminal voltage of the semiconductor laser 1. It is therefore possible to extract the MHP waveform from the inter-terminal voltage of the semiconductor laser 1.

The filter unit 6 has a function of extracting a superimposed signal from a modulated wave as in the first to fourth embodiments, and extracts an MHP waveform from an output voltage from the voltage detection unit 11. The operations of the semiconductor laser 1, a laser driver 4, a period discrimination unit 7, a determination unit 8, and a display unit 9 are the same as those in the first to fourth embodiments.

In this manner, this embodiment can extract an MHP waveform without using any photodiode, and hence can reduce the number of the parts of the BGS photoelectric switch as compared with the first to fourth embodiments. This makes it possible to reduce the cost of the BGS photoelectric switch.

According to the present invention, it is possible to effectively remove the influences of mode hop pulse dropout or excessive noise detection at the time of measurement of periods, and to properly determine whether the distance from the reflective photoelectric switch to the object is longer or shorter than the reference distance. In addition, the period measuring means, the counting means, and the determination means can be implemented by simple arrangements, thereby implementing a high-accuracy reflective photoelectric switch with a simple, inexpensive arrangement.

In addition, according to the present invention, providing a frequency correcting means makes it possible to more effectively remove the influences of excessive noise detection at the time of measurement of periods and to further improve the determination accuracy concerning the distance to an object.

**Claims**

1. A reflective photoelectric switch **characterized by** comprising:

    a semiconductor laser (1) which emits laser light;
    a laser driver (4) which drives said semiconductor laser;
    detection means (2) for detecting an electrical signal including an interference waveform generated by a self-mixing effect between laser light emitted from said semiconductor laser and return light from an object (10) existing ahead of said semiconductor laser;
    period measuring means (70) for measuring a period of an interference waveform included in an output signal from said detection means every time an interference waveform is input;
    counting means (71) for discriminating frequencies of periods of interference waveforms measured by said period measuring means into four frequencies including a frequency N1 of periods less than a first predetermined number multiple of a reference period which is a period of an interference waveform when the object is located at a reference distance, a frequency N2 of periods not less than the first predetermined number multiple of the reference period and less than the reference period, a frequency N3 of periods not less than the reference period and less than a second predetermined number multiple of the reference period (first predetermined number < second predetermined number), and a frequency N4 of periods not less than the second predetermined number multiple of the reference period; and
    determination means (8) for comparing in magnitude the frequency N1, the frequency N4, and a frequency sum (N2 + N3), determining that the object exists at a distance longer than the reference distance, when the frequency N1 is largest, determining that the object exists at a distance shorter than the reference distance, when the frequency N4 is largest, comparing in magnitude the frequency N2 with the frequency N3 when the frequency sum (N2 + N3) is largest, determining that the object exists at a distance longer than the reference distance, when the frequency N2 is larger, and determining that the object exists at a distance shorter than the reference distance, when the frequency N3 is larger.

2. A switch according to claim 1, further comprising frequency correcting means (74) for calculating a correction value N2' (= N2 - N1) for the frequency N2,
wherein said determination means compares in magnitude the frequency N1, the frequency N4, and the frequency sum (N2 + N3), determines that the object exists at a distance longer than the reference distance, when the frequency N1 is largest, determines that the object exists at a distance shorter than the reference distance, when the frequency N4 is largest, compares in magnitude the correction value N2' for the frequency with the frequency N3 when the frequency sum (N2 + N3) is largest, determines that the object exists at a distance longer than the reference distance, when the correction value N2' is larger, and determines that the object exists at a distance shorter than the reference distance, when the frequency N3 is larger.

3. A switch according to claim 1, further comprising frequency correcting means (74) for calculating a correction value N3' (= N3 + N1) for the frequency N3,
wherein said determination means compares in magnitude the frequency N1, the frequency N4, and the frequency sum (N2 + N3), determines that the object exists at a distance longer than the reference distance, when the frequency N1 is largest, determines that the object exists at a distance shorter than the reference distance, when the frequency N4 is largest, compares in magnitude the frequency N2 with the correction value N3' for the frequency when the frequency sum (N2 + N3) is largest, determines that the object exists at a distance longer than the reference distance, when the frequency N2 is larger, and determines that the object exists at a distance shorter than the reference distance, when the correction value N3' is larger.

4. A switch according to claim 1, wherein said laser driver drives said semiconductor laser such that a first oscillation interval including at least an interval in which the oscillation wavelength continuously and monotonously increases and a second oscillation interval including at least an interval in which the oscillation wavelength continuously and monotonously decreases alternately exist.

5. A switch according to claim 4, further comprising:

normalization means (75) for normalizing the frequencies N1, N2, N3, and N4 obtained by said counting means for each oscillation interval with frequencies in each oscillation interval, and obtaining frequencies N1", N2", N3", and N4" by adding each of the normalized frequencies N1, N2, N3, and N4 in the first oscillation interval to a corresponding one of the normalized frequencies N1, N2, N3, and N4 in the second oscillation interval; and frequency correcting means (76) for calculating a correction value N2' (= N2" - N1") for the frequency N2", wherein said determination means compares in magnitude the frequency N1", the frequency N4", and a frequency sum (N2" + N3"), determines that the object exists at a distance longer than the reference distance, when the frequency N1" is largest, determines that the object exists at a distance shorter than the reference distance, when the frequency N4" is largest, compares in magnitude the correction value N2' for the frequency with the frequency N3" when the frequency sum (N2" + N3") is largest, determines that the object exists at a distance longer than the reference distance, when the correction value N2' is larger, and determines that the object exists at a distance shorter than the reference distance, when the frequency N3" is larger.

6. A switch according to claim 4, further comprising:

normalization means (75) for normalizing the frequencies N1, N2, N3, and N4 obtained by said counting means for each oscillation interval with frequencies in each oscillation interval, and obtaining frequencies N1", N2", N3", and N4" by adding each of the normalized frequencies N1, N2, N3, and N4 in the first oscillation interval to a corresponding one of the normalized frequencies N1, N2, N3, and N4 in the second oscillation interval; and frequency correcting means (76) for calculating a correction value N3' (= N3" + N1") for the frequency N3", wherein said determination means compares in magnitude the frequency N1", the frequency N4", and a frequency sum (N2" + N3"), determines that the object exists at a distance longer than the reference distance, when the frequency N1" is largest, determines that the object exists at a distance shorter than the reference distance, when the frequency N4" is largest, compares in magnitude the frequency N2" with the correction value N3' for the frequency when the frequency sum (N2" + N3") is largest, determines that the object exists at a distance longer than the reference distance, when the frequency N2" is larger, and determines that the object exists at a distance shorter than the reference distance, when the correction value N3' is larger.

7. A switch according to any one of claims 1 to 6, wherein the first predetermined number is 0.5, and the second predetermined number is 1.5.

8. An object detection method **characterized by** comprising the steps of:

driving a semiconductor laser by supplying a driving current thereto;
detecting an electrical signal including an interference waveform generated by a self-mixing effect between laser light emitted from the semiconductor laser and return light from an object existing ahead of the semiconductor laser;
measuring a period of an interference waveform included in a detected electrical signal every time an interference waveform is input;
discriminating frequencies of measured periods of interference waveforms into a frequency N1 of periods less than a first predetermined number multiple of a reference period which is a period of an interference waveform when the object is located at a reference distance, a frequency N2 of periods not less than the first predetermined number multiple of the reference period and less than the reference period, a frequency N3 of periods not less than the reference period and less than a second predetermined number multiple of the reference period (first predetermined number < second predetermined number), and a frequency N4 of periods not less than the second predetermined number multiple of the reference period; and
comparing in magnitude the frequency N1, the frequency N4, and a frequency sum (N2 + N3), determining that the object exists at a distance longer than the reference distance, when the frequency N1 is largest, determining that the object exists at a distance shorter than the reference distance, when the frequency N4 is largest, comparing in magnitude the frequency N2 with the frequency N3 when the frequency sum (N2 + N3) is largest, determining that the object exists at a distance longer than the reference distance, when the frequency N2 is larger, and determining that the object exists at a distance shorter than the reference distance, when the frequency N3 is larger.

9. A method according to claim 8, further comprising the step of calculating a correction value N2' (= N2 - N1) for the frequency N2,
wherein the step of determining comprises the step of comparing in magnitude the frequency N1, the frequency N4, and the frequency sum (N2 + N3), determining that the object exists at a distance longer than the reference distance, when the frequency N1 is largest, determining that the object exists at a distance shorter than the reference distance, when the frequency N4 is largest, comparing in magnitude the correction value N2' for the frequency with the frequency N3 when the frequency sum (N2 + N3) is largest, determining that the object exists at a distance longer than the reference distance, when the correction value N2' is larger, and determining that the object exists at a distance shorter than the reference distance, when the frequency N3 is larger.

10. A method according to claim 8, further comprising the step of calculating a correction value N3' (= N3 + N1) for the frequency N3,
wherein the step of determining comprises the step of comparing in magnitude the frequency N1, the frequency N4, and the frequency sum (N2 + N3), determining that the object exists at a distance longer than the reference distance, when the frequency N1 is largest, determining that the object exists at a distance shorter than the reference distance, when the frequency N4 is largest, comparing in magnitude the frequency N2 with the correction value N3' for the frequency when the frequency sum (N2 + N3) is largest, determining that the object exists at a distance longer than the reference distance, when the frequency N2 is larger, and determining that the object exists at a distance shorter than the reference distance, when the correction value N3' is larger.

11. A method according to claim 8, wherein the step of driving comprises the step of driving the semiconductor laser such that a first oscillation interval including at least an interval in which the oscillation wavelength continuously and monotonously increases and a second oscillation interval including at least an interval in which the oscillation wavelength continuously and monotonously decreases alternately exist.

12. A method according to claim 11, further comprising the steps of:

normalizing the obtained frequencies N1, N2, N3, and N4 for each oscillation interval with frequencies in each oscillation interval, and obtaining frequencies N1", N2", N3", and N4" by adding each of the normalized frequencies N1, N2, N3, and N4 in the first oscillation interval to a corresponding one of the normalized frequencies N1, N2, N3, and N4 in the second oscillation interval; and
calculating a correction value N2' (= N2" - N1") for the frequency N2",

wherein the step of determining further comprises the step of comparing in magnitude the frequency N1", the frequency N4", and a frequency sum (N2" + N3"), determining that the object exists at a distance longer than the reference distance, when the frequency N1" is largest, determining that the object exists at a distance shorter than the reference distance, when the frequency N4" is largest, comparing in magnitude the correction value N2' for the frequency with the frequency N3" when the frequency sum (N2" + N3") is largest, determining that the object exists at a distance longer than the reference distance, when the correction value N2' is larger, and determining that the object exists at a distance shorter than the reference distance, when the frequency N3" is larger.

13. A method according to claim 11, further comprising the steps of:

normalizing the obtained frequencies N1, N2, N3, and N4 for each oscillation interval with frequencies in each oscillation interval, and obtaining frequencies N1", N2", N3", and N4" by adding each of the normalized frequencies N1, N2, N3, and N4 in the first oscillation interval to a corresponding one of the normalized frequencies N1, N2, N3, and N4 in the second oscillation interval; and
calculating a correction value N3' (= N3" + N1") for the frequency N3",
wherein the step of determining further comprises the step of comparing in magnitude the frequency N1", the frequency N4", and a frequency sum (N2" + N3"), determining that the object exists at a distance longer than the reference distance, when the frequency N1" is largest, determining that the object exists at a distance shorter than the reference distance, when the frequency N4" is largest, comparing in magnitude the frequency N2" with the correction value N3' for the frequency when the frequency sum (N2" + N3") is largest, determining that the object exists at a distance longer than the reference distance, when the frequency N2" is larger, and determining that the object exists at a distance shorter than the reference distance, when the correction value N3' is larger.

14. A method according to any one of claims 8 to 13, wherein the first predetermined number is 0.5, and the second predetermined number is 1.5.

F I G . 1

F I G . 2

VOLTAGE

TIME

# FIG.3A

VOLTAGE

P1  P2  P1  P2  P1

TIME

# FIG.3B

7

PERIOD MEASURING UNIT 70

| LEADING EDGE DETECTION UNIT | TIME MEASURING UNIT | COUNTING UNIT |

72   73   71

# FIG.4

FIG. 5

FIG. 6

16

FIG.7

FIG.8

FIG. 9

FIG. 10

F I G . 1 1

F I G . 1 2

FIG.13

FIG.14

Europäisches
Patentamt

European
Patent Office

Office européen
des brevets

# EUROPEAN SEARCH REPORT

Application Number

EP 09 00 6285

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 953 567 A2 (YAMATAKE CORP [JP]) 6 August 2008 (2008-08-06) * abstract; claims 1,5; figures 1,3A,3B * * paragraphs [0004], [0019] - [0026] * ----- | 1,8 | INV. G01S7/491 G01S17/02 G01S17/32 H03K17/94 |
| A | US 4 564 756 A (JOHNSON MARK [US]) 14 January 1986 (1986-01-14) * abstract * * column 1, lines 14-39 * * column 2, line 31 - column 3, line 11 * ----- | 1,8 | |
| A | DE 39 43 470 A1 (THIESSEN RAINER [DE]) 13 December 1990 (1990-12-13) * column 1, lines 3-12 * * column 5, lines 45-55 * * column 7, lines 35-58 * ----- | 1,8 | |
| A | JP 2007 108122 A (YAMATAKE CORP) 26 April 2007 (2007-04-26) * abstract * * paragraphs [0001], [0003], [0004], [0013] * ----- | 1,8 | |
| A | CHRISTIAN M VON DER LIPPE ET AL: "ADVANCED OPTICAL FUZING TECHNOLOGY" PROCEEDINGS OF THE SPIE - THE INTERNATIONAL SOCIETY FOR OPTICAL ENGINEERING, SPIE, US, vol. 5871, no. 1, 1 January 2005 (2005-01-01), pages 58710I-1, XP007910388 ISSN: 0277-786X * abstract * * chapters 1, 5 * ----- | 1,8 | TECHNICAL FIELDS SEARCHED (IPC) G01S H03K |

The present search report has been drawn up for all claims

| Place of search | Date of completion of the search | Examiner |
|---|---|---|
| Munich | 10 November 2009 | Grübl, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 2 251 707 A1

## ANNEX TO THE EUROPEAN SEARCH REPORT
## ON EUROPEAN PATENT APPLICATION NO.

EP 09 00 6285

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2009

| Patent document cited in search report | | | Publication date | Patent family member(s) | | | Publication date |
|---|---|---|---|---|---|---|---|
| EP 1953567 | | A2 | 06-08-2008 | KR | 20080070545 | A | 30-07-2008 |
| | | | | US | 2008181354 | A1 | 31-07-2008 |
| US 4564756 | | A | 14-01-1986 | DE | 3478840 | D1 | 03-08-1989 |
| | | | | EP | 0149123 | A2 | 24-07-1985 |
| | | | | JP | 1638510 | C | 31-01-1992 |
| | | | | JP | 3001625 | B | 11-01-1991 |
| | | | | JP | 60147670 | A | 03-08-1985 |
| DE 3943470 | | A1 | 13-12-1990 | US | 5097476 | A | 17-03-1992 |
| JP 2007108122 | | A | 26-04-2007 | NONE | | | |

EPO FORM P0459

For more details about this annex : see Official Journal of the European Patent Office, No. 12/82

22

## REFERENCES CITED IN THE DESCRIPTION

### Patent documents cited in the description

- JP 63102135 A
- JP 63187237 A
- JP 2007015020 A

### Non-patent literature cited in the description

- Distance Meter Using Self-Mixing Effect of Semiconductor Laser. **Tadashi Ueda ; Jun Yamada ; Susumu Shitoh.** Papers for 1994 Tokai-Section Joint Conference of the 8 Institutes of Electrical and Related Engineers. 1994
- **Jun Yamada ; Susumu Shitoh ; Norio Tuda ; Tadashi Ueda.** Study of Compact Distance Meter by Self-Mixing Effect of Laser Diode. *Bulletin of Aichi Institute of Technology,* 1996, vol. 31B, 35-42
- **Guido Giuliani ; Michele Norgia ; Silvano Donati ; Thierry Bosch.** Laser diode self-mixing technique for sensing applications. *JOURNAL OF OPTICS A: PURE AND APPLIED OPTICS,* 2002, 283-294